# EUROPEAN PATENT APPLICATION

(11) **EP 3 115 760 A1**
(43) Date of publication of application: **11.01.2017**
(21) Application number: 15757767.7
(22) Date of filing: 04.03.2015
(51) Int. Cl.: G01K 7/32, G01K 1/02

(54) **WIRELESS TEMPERATURE SENSOR**

(30) Priority: 06.03.2014 JP 2014043932; 06.06.2014 JP 2014117648
(71) Applicant: Citizen Holdings Co., Ltd., Nishitokyo-shi, Tokyo 188-8511 (JP)
(72) Inventor: ARAI, Isao, Nishitokyo-shi, Tokyo 188-8511 (JP); KOMINE, Shinichi, Nishitokyo-shi, Tokyo 188-8511 (JP); NONOGAKI, Youichi, Nishitokyo-shi, Tokyo 188-8511 (JP); SOHDA, Satoshi, Nishitokyo-shi, Tokyo 188-8511 (JP); KINOSHITA, Yoshitaka, Nishitokyo-shi, Tokyo 188-8511 (JP)
(74) Representative: Krauns, Christian
(86) International application number: PCT/JP2015/056411
(87) International publication number: WO 2015/133541

(57) **Abstract**

A wireless temperature sensor that has an ease of manufacture and an improved reliability is provided. The wireless temperature sensor includes a first structure having an antenna having an antenna electrode and a GND electrode disposed in an insulating substrate, a temperature detection device fixed on an opposite surface of the first structure to a surface in which the antenna electrode is disposed, and a second structure disposed on the side of a side wall of the temperature detection device and joined to the first structure. The temperature detection device is fixed on the first structure so as to be electrically connected to the antenna electrode and the GND electrode.

## Description

### TECHNICAL FIELD

The present invention relates to a wireless temperature sensor.

### BACKGROUND ART

There are several methods for temperature measurement using cables. For example, methods of using temperature-resistance characteristics or thermal electromotive force of a thermistor or a thermocouple, radiation thermometers that measure a temperature using infrared rays radiating from an object, methods of using the principle that physical characteristics of a piezoelectric element or a surface acoustic wave device vary with temperature are known.

However, for example, in the case of measuring the temperature of a wafer in a chamber during a semiconductor manufacturing process, where to route an output cable, which is connected to output from a measurement portion disposed in the chamber to the outside, is subject to constraints of the chamber, accompanying devices, and the like. As a solution of this problem, a wireless temperature sensor is known in which a unit comprising a surface acoustic wave device with a transmitting and receiving antenna provided therein is operated by a signal transmitted from an external antenna, and sends back a response signal including measurement information (for example, refer to patent document 1).

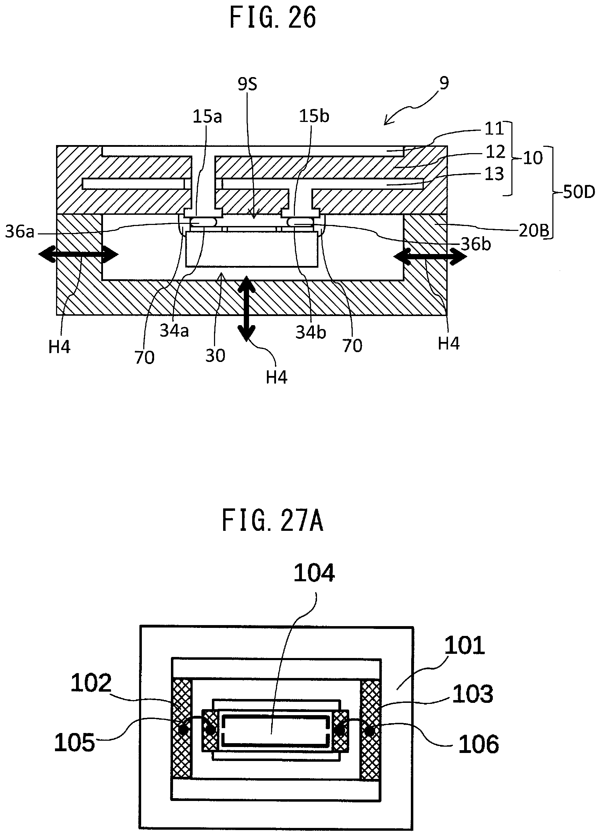

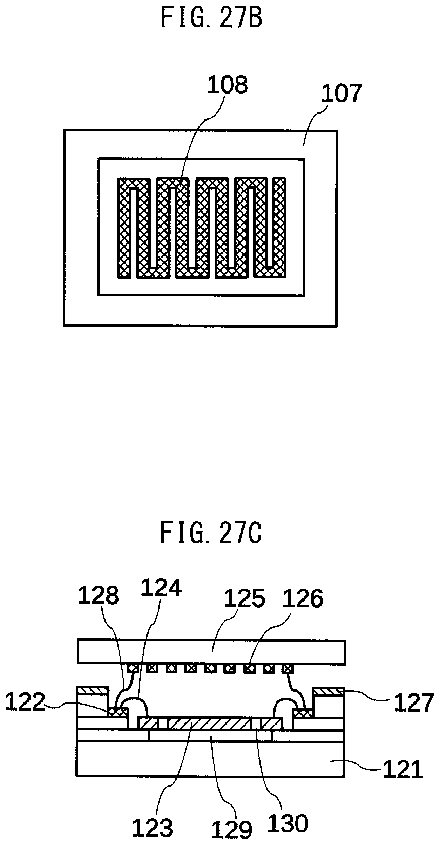

FIG. 27A is a plan view of a container body 101 of a temperature sensor according to a first embodiment of the patent document 1, and FIG. 27B is a plan view of a lid 107 thereof. As shown in FIG. 27A, electrodes attached to a diaphragm 104 are connected to external terminals 102 and 103 attached to the container body 101 by lead wires 105 and 106, respectively. Also, as shown in FIG. 27B, a coil 108 formed in the lid 107 is connected to the external terminals 102 and 103 at its both ends by not-shown lead wires.

FIG. 27C is a sectional view of a temperature sensor, before sealing a container body 121 with a lid 125 in an airtight manner, according to a second embodiment of the patent document 1. A diaphragm 123 having grooves 130 is attached to the container body 121. A coil 126 is formed on the lid 125. The diaphragm 123, which is attached to the container body 121, is connected to external terminals 122 by lead wires 124. The external terminals 122 are connected to the coil 126 by lead wires 128. After that, the container body 121 is sealed with the lid 125 in an airtight manner.

In either of the above first and second embodiments, the diaphragm (104 or 123) provided on the container body (101 or 121) is connected to the coil (108 or 126) provided on the lid (107 or 125) by the lead wires.

### PRIOR ART DOCUMENT

### PATENT DOCUMENT

Patent document 1: Japanese Patent No. 5341381

### SUMMARY OF THE INVENTION

However, in such a manufacturing method in which after the lid and the container body, which are prepared separately, are connected by the lead wires, the lid is mounted on the container body so as to contain the lead wires in the container body, the lead wires may bend and break during the mounting, or the bent lead wires may contact the diaphragm after the mounting, thus causing a malfunction.

The present invention intends to solve the above problems, and an object of the present invention is to provide a wireless temperature sensor that has an ease of manufacture and an improved reliability.

The wireless temperature sensor includes a first structure having an antenna having an antenna electrode and a GND electrode disposed in an insulating substrate, a temperature detection device fixed on an opposite surface of the first structure to a surface in which the antenna electrode is disposed, and a second structure disposed on the side of a side wall of the temperature detection device and joined to the first structure. The temperature detection device is fixed on the first structure so as to be electrically connected to the antenna electrode and the GND electrode.

In the wireless temperature sensor, the temperature detection device may be fixed so as to contact the inside of the second structure.

In the wireless temperature sensor, the second structure may have an opening on the opposite side to the side joined to the first structure.

The wireless temperature sensor may further include a thermal conductor disposed between the second structure and the temperature detection device.

In the wireless temperature sensor, the second structure may have a porous structure or a mesh structure.

The wireless temperature sensor may further include a thermal conductive layer that is formed in the insulating substrate and thermally connected to the temperature detection device and the second structure.

The wireless temperature sensor may further include a via hole formed in the insulating substrate so as to conduct between the GND electrode and the thermal conductive layer. The temperature detection device may be fixed on the via hole on the thermal conductive layer.

In the wireless temperature sensor, the first structure may be formed from a first ceramic substrate having a lower firing temperature than a second ceramic substrate, while the second structure may be formed from the second ceramic substrate having a higher firing temperature than the first ceramic substrate.

In the wireless temperature sensor, the first ceramic substrate may be made of LTCC, while the second ceramic substrate may be made of HTCC.

In the wireless temperature sensor, the antenna electrode and the GND electrode may be made of silver (Ag) or copper (Cu).

The wireless temperature sensor may further include a protective layer for covering the antenna electrode.

According to the above wireless temperature sensor, the temperature detection device is fixed on the first structure in which the antenna electrode and the GND electrode are disposed in the insulating substrate. Therefore, it is possible to provide the wireless temperature sensor that has an ease of manufacture and an improved reliability.

A method for manufacturing the wireless temperature sensor may include the steps of preparing the first structure having the insulating substrate and the second structure, forming the antenna by disposing the antenna electrode and the GND electrode in the first structure having the insulating substrate, fixing the temperature detection device on the first structure such that the temperature detection device is electrically connected to the antenna electrode and the GND electrode, and joining and assembling the first structure and the second structure such that the second structure is disposed on the side of the side wall of the temperature detection device.

A method for manufacturing the wireless temperature sensor may include the steps of forming the second structure by preparing a first ceramic green sheet and a second ceramic green sheet, and firing the second ceramic green sheet having a higher thermal conductivity than the first ceramic green sheet, forming the first structure having the antenna by disposing the antenna electrode and the GND electrode in the first ceramic green sheet, and firing the first ceramic green sheet in which the antenna electrode and the GND electrode are disposed at a lower firing temperature than that of the second ceramic green sheet, electrically connecting the temperature detection device to the antenna electrode and the GND electrode, and joining the second structure and the first structure such that the temperature detection device is fixed within the second structure and the first structure.

The objects and effects of the present invention will be recognized and obtained with the use of components described in claims, in particular, and combinations of the components. Both of the aforementioned general description and the undermentioned detailed description are exemplary and explanatory, but do not limit the present invention mentioned in the scope of claims.

### BRIEF DESCRIPTION OF THE DRAWINGS

FIG. 1 is a drawing for explaining the structure of a wireless temperature sensor 1;
FIG. 2A is a plan view of a temperature detection device 30;
FIG. 2B is a cross sectional view of the temperature detection device 30 taken along line C-C of FIG. 2A;
FIG. 2C is a cross sectional view of the temperature detection device 30 taken along line D-D of FIG. 2A;
FIG. 3A is a plan view of the wireless temperature sensor 1;
FIG. 3B is a side view of the wireless temperature sensor 1;
FIG. 4 is a cross sectional view of the wireless temperature sensor 1 taken along line B-B of FIG. 3B;
FIG. 5 is a drawing for explaining a temperature detection method by the wireless temperature sensor 1;
FIG. 6 is a graph showing variations in the strength Rwp of a reflected surface acoustic wave with time in a surface acoustic wave device;
FIG. 7 is a drawing for explaining the configuration of a temperature measurement system using the wireless temperature sensors 1;
FIG. 8 is a flowchart showing an overview of a method for manufacturing the wireless temperature sensor 1;
FIG. 9A is a drawing for explaining a first structure assembly process of the wireless temperature sensor 1;
FIG. 9B is a drawing for explaining the first structure assembly process of the wireless temperature sensor 1;
FIG. 9C is a drawing for explaining the first structure assembly process of the wireless temperature sensor 1;
FIG. 9D is a drawing for explaining the first structure assembly process of the wireless temperature sensor 1;
FIG. 9E is a drawing for explaining the first structure assembly process of the wireless temperature sensor 1;
FIG. 9F is a drawing for explaining the first structure assembly process of the wireless temperature sensor 1;
FIG. 10A is a drawing for explaining a temperature detection device mounting process of the wireless temperature sensor 1;
FIG. 10B is a drawing for explaining the temperature detection device mounting process of the wireless temperature sensor 1;
FIG. 10C is a drawing for explaining the temperature detection device mounting process of the wireless temperature sensor 1;
FIG. 10D is a drawing for explaining the temperature detection device mounting process of the wireless temperature sensor 1;
FIG. 11A is a drawing for explaining a container assembly process of the wireless temperature sensor 1;
FIG. 11B is a drawing for explaining the container assembly process of the wireless temperature sensor 1;
FIG. 11C is a drawing for explaining the container assembly process of the wireless temperature sensor 1;
FIG. 11D is a drawing for explaining the container assembly process of the wireless temperature sensor 1;
FIG. 11E is a drawing for explaining the container assembly process of the wireless temperature sensor 1;
FIG. 11F is a drawing for explaining the container assembly process of the wireless temperature sensor 1;
FIG. 11G is a drawing for explaining the container assembly process of the wireless temperature sensor 1;
FIG. 12 is a drawing for explaining the structure of another wireless temperature sensor 2;
FIG. 13A is a drawing for explaining a first structure assembly process of the wireless temperature sensor 2;
FIG. 13B is a drawing for explaining the first structure assembly process of the wireless temperature sensor 2;
FIG. 13C is a drawing for explaining the first structure assembly process of the wireless temperature sensor 2;
FIG. 13D is a drawing for explaining the first structure assembly process of the wireless temperature sensor 2;
FIG. 13E is a drawing for explaining the first structure assembly process of the wireless temperature sensor 2;
FIG. 13F is a drawing for explaining the first structure assembly process of the wireless temperature sensor 2;
FIG. 14 is a drawing for explaining the structure of yet another wireless temperature sensor 3;
FIG. 15A is a sectional view which schematically shows a heat transfer path of the wireless temperature sensor 2 from a not shown object to be measured;
FIG. 15B is a sectional view which schematically shows a heat transfer path of the wireless temperature sensor 3 from a not shown object to be measured;
FIG. 16 is a drawing for explaining the structure of yet another wireless temperature sensor 4;
FIG. 17A is a drawing for explaining a method for manufacturing the wireless temperature sensor 4;
FIG. 17B is a drawing for explaining the method for manufacturing the wireless temperature sensor 4;
FIG. 17C is a drawing for explaining the method for manufacturing the wireless temperature sensor 4;
FIG. 17D is a drawing for explaining the method for manufacturing the wireless temperature sensor 4;
FIG. 17E is a drawing for explaining the method for manufacturing the wireless temperature sensor 4;
FIG. 17F is a drawing for explaining the method for manufacturing the wireless temperature sensor 4;
FIG. 17G is a drawing for explaining the method for manufacturing the wireless temperature sensor 4;
FIG. 18 is a drawing for explaining the structure of yet another wireless temperature sensor 5;
FIG. 19A is a drawing for explaining a temperature detection device mounting process of the wireless temperature sensor 5;
FIG. 19B is a drawing for explaining the temperature detection device mounting process of the wireless temperature sensor 5;
FIG. 19C is a drawing for explaining the temperature detection device mounting process of the wireless temperature sensor 5;
FIG. 20 is a drawing for explaining the structure of yet another wireless temperature sensor 6;
FIG. 21 is a drawing in which the wireless temperature sensor 6 is viewed from a direction 6D in FIG. 20;
FIG. 22 is a drawing for explaining the structure of yet another wireless temperature sensor 7;
FIG. 23 is a drawing in which the wireless temperature sensor 7 is viewed from a direction 7D in FIG. 22;
FIG. 24 is a drawing for explaining the structure of yet another wireless temperature sensor 8;
FIG. 25A is a drawing for explaining a temperature detection device mounting process and an entirety assembly process of the wireless temperature sensor 8;
FIG. 25B is a drawing for explaining the temperature detection device mounting process and the entirety assembly process of the wireless temperature sensor 8;
FIG. 25C is a drawing for explaining the temperature detection device mounting process and the entirety assembly process of the wireless temperature sensor 8;
FIG. 26 is a drawing that explains the structure of yet another wireless temperature sensor 9;
FIG. 27A is a plan view that shows a piezoelectric vibrator, a temperature sensor, and a temperature measurement method according to a conventional example;
FIG. 27B is a plan view that shows the piezoelectric vibrator, the temperature sensor, and the temperature measurement method according to the conventional example; and
FIG. 27C is a plan view that shows the piezoelectric vibrator, the temperature sensor, and the temperature measurement method according to the conventional example.

### EMBODIMENTS OF THE INVENTION

Embodiments of a wireless temperature sensor according to the present invention will be described below with reference to the drawings. However, the technical scope of the present invention is not limited to the embodiments but extends to the invention described in claims and equivalents thereof. Note that, correct dimensions are not reflected in each of the drawings. Some components may be exaggerated in size, while some other components may be omitted for the purpose of illustration. The same reference numerals indicate the same components and repeated explanation thereof is omitted.

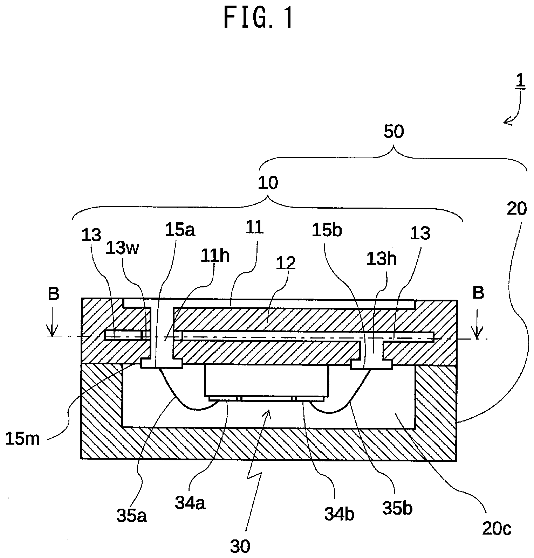

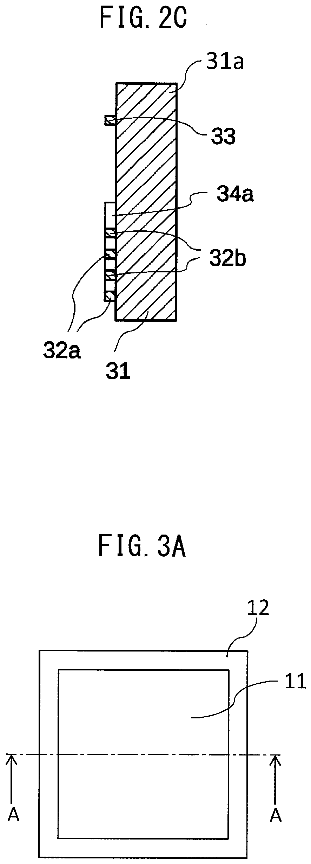

FIG. 1 is a drawing for explaining the structure of a wireless temperature sensor 1. Note that, FIG. 1 is a sectional view of the wireless temperature sensor 1 taken along line A-A of FIG. 3A.

As shown in FIG. 1, the wireless temperature sensor 1 includes a container 50 constituted of a lid 10 and a container body 20, and a temperature detection device 30 fixed within the container 50. The temperature detection device 30 is mounted on the lid 10.

The lid 10, which is a first structure formed from a first ceramic substrate, is a microstrip antenna (hereafter called antenna) in which an antenna electrode layer 11 and a GND electrode layer 13 are laminated on an insulating substrate 12. The microstrip antenna, which is also called planar antenna or patch antenna, is an antenna which has a high gain, a narrow band, and a wide directivity in a compact and slim body.

The insulating substrate 12 has a thickness of approximately 1 mm and is made of CaO-Al₂O₃-SiO₂-B₂O₃, which is a low temperature fired ceramic material known as LTCC (low temperature cofired ceramics) in general. However, the insulating substrate 12 is not limited to this but may be made of another LTCC material. The LTCC material includes BaO-Al₂O₃-SiO₂-Bi₂O₃, BaOTiO₂-ZnO, BaO-Nd₂O₃-Bi₂O₃-TiO₂, BaO-R₂O₃-TiO₂ (R is an alkali metal), and the like. Note that, since Ag or Cu having a high electrical conductivity is preferably used in a conductor pattern formed in the lid 10, as described later, the LTCC material preferably has a lower firing temperature than the melting point (approximately 1083°C) of Cu or the melting point (approximately 961°C) of Ag.

The thickness of the insulating substrate 12 is not limited to approximately 1 mm but is variable depending on the used ceramic material, as long as the thickness is sufficient for ensuring the characteristics of the antenna.

The insulating substrate 12 may be made of a high temperature fired ceramic material having a high thermal conductivity known as HTCC (high temperature cofired ceramics) in general. The HTCC material includes, for example, aluminum oxide (Al₂O₃), aluminum nitride (AlN), and the like.

The antenna electrode layer 11 is an electrode layer which is made of Cu and has a thickness of the order of 10 to 15 µm. The antenna electrode layer 11 may have another thickness. The antenna electrode layer 11 is electrically connected to an antenna connection pad 15a, which is a first electrode pad provided on a lid mounting surface 15m of the insulating substrate 12, through an antenna via hole 11h, which is a first via hole penetrating the insulating substrate 12. The antenna via hole 11h and the antenna connection pad 15a are made of Cu.

The GND electrode layer 13 is an electrode layer that is made of Cu and has a thickness of the order of 10 to 15 µm. The GND electrode layer 13 may have another thickness. The GND electrode layer 13 is electrically connected to a GND connection pad 15b, which is a second electrode pad provided on the lid mounting surface 15m of the insulating substrate 12, through a GND via hole 13h, which is a second via hole provided in the insulating substrate 12. The GND electrode layer 13 is provided with a GND pattern opening 13w through which the antenna via hole 11h penetrates. It is noted that the GND pattern opening 13w may be filled with the ceramic material that forms the insulating substrate 12. The GND via hole 13h and the GND connection pad 15b are made of Cu.

The above conductor pattern (that is, the antenna electrode layer 11, the antenna via hole 11h, the antenna connection pad 15a, the GND electrode layer 13, the GND via hole 13h, and the GND connection pad 15b) is made of Cu, but may be made of another metal. The conductor pattern is preferably made of Ag or Cu having a high electrical conductivity. Especially when the insulating substrate 12 of the lid 10 is formed using the LTCC material, the use of Ag or Cu having a high electrical conductivity allows the obtainment of efficient antenna characteristics.

The container body 20, which is a second structure formed from a second ceramic substrate, is formed of Al₂O₃, which is a high temperature fired ceramic material known as the HTCC in general. In the container body 20, a body cavity 20c is formed in a method described below. The container body 20 may be made of another HTCC material such as aluminum nitride (AlN), instead of Al₂O₃.

Furthermore, the container body 20 may be made of another ceramic material such as the LTCC described above, a rigid substrate having a high relative dielectric constant, a polymeric material such as a polyimide, a metal having an oxide film, or the like, instead of the HTCC.

The temperature detection device 30 is mounted on the lid mounting surface 15m of the insulating substrate 12 of the lid 10. The temperature detection device 30 has device bonding pads 34a and 34b. The device bonding pad 34a is connected to the antenna connection pad 15a, that is, the first electrode pad by a bonding wire 35a. The device bonding pad 34b is connected to the GND connection pad 15b, that is, the second electrode pad by a bonding wire 35b. Thus, the device bonding pad 34a is electrically connected to the antenna electrode layer 11, while the device bonding pad 34b is electrically connected to the GND electrode layer 13.

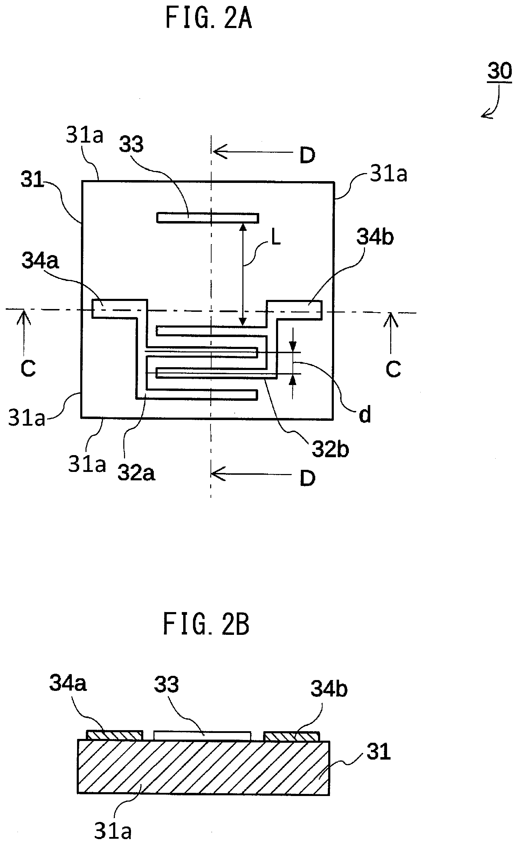

FIG. 2A is a plan view of the temperature detection device 30. FIG. 2B is a cross sectional view of the temperature detection device 30 taken along line C-C of FIG. 2A. FIG. 2C is a cross sectional view of the temperature detection device 30 taken along line D-D of FIG. 2A.

In FIG. 2A, the temperature detection device 30 is a surface acoustic wave device which has a surface acoustic wave device substrate 31, comb electrodes 32a and 32b and a reflector 33 provided on a surface of the surface acoustic wave device substrate 31. The device bonding pad 34a is formed at an end of the comb electrode 32a, and the device bonding pad 34b is formed at an end of the comb electrode 32b. The surface acoustic wave device substrate 31 has four side walls 31a which are approximately perpendicular to the surface in which the comb electrodes 32a and 32b and the reflector 33 are formed.

The surface acoustic wave device substrate 31 is made of a single crystal of lithium niobate (LiNbO₃), and has the shape of a square plate having dimensions of approximately 10 mm × 10 mm in a plan view and a thickness of approximately 2 mm. The surface acoustic wave device substrate 31 is not limited to this, but may be a single crystal substrate made of a piezoelectric material, a substrate in which a piezoelectric thin film is formed on a glass substrate or a Si substrate, or the like. The piezoelectric material includes, but is not limited thereto, lithium tantalate (LiTaO₃), quartz (SiO₂), langasite (La₃Ga₅SiO₁₄), langatate (La₃Ta_{0.5}Ga_{5.5}O₁₄), and the like.

The comb electrodes 32a and 32b are formed in one surface of the surface acoustic wave device substrate 31 such that two pairs of electrodes are arranged alternately. The comb electrodes 32a and 32b are formed of Cu by sputtering. However, the comb electrodes 32a and 32b may be made of another electrode material such as Au, Ti, Ni, chrome (Cr), or aluminum (Al) other than Cu by a film forming method other than sputtering.

The interelectrode distance d between the comb electrodes 32a and 32b is required to have a value depending on the wavelengths of surface acoustic waves excited by the surface acoustic wave device. When v represents the propagation velocity of a surface acoustic wave, λ represents the wavelength of the surface acoustic wave, and f represents the excitation frequency of the comb electrodes, these are related as v=f×λ and d=λ/2. Taking lithium niobate as an example, when the excitation frequency is 2.45 GHz, the interelectrode distance d has to be approximately 0.8 µm.

In the comb electrodes 32a and 32b, the width of each electrode and the interelectrode distance between adjoining electrodes are preferably equal. In the above case, the width of each electrode is more preferably approximately 0.4 µm, that is, half of the interelectrode distance d. Since the propagation velocity v varies depending on the material for the surface acoustic wave device substrate 31 in which the surface acoustic waves are produced, the interelectrode distance d can be chosen appropriately depending on an arbitrary material and a difference in frequency.

The reflector 33 is formed in the surface of the surface acoustic wave device substrate 31 on which the comb electrodes 32a and 32b are formed, with substantially the same dimensions as the comb electrodes 32a and 32b. The reflector 33 is formed of Cu by sputtering, just as with the comb electrodes 32a and 32b. However, the reflector 33 may be formed using an electrode material other than Cu, e.g. Au, Ti, Ni, chrome (Cr), or aluminum (Al), by a method other than sputtering.

The reflector 33 is provided in order to reflect the surface acoustic waves which are induced in the surface of the surface acoustic wave device substrate 31 by the application of a high frequency signal to the comb electrodes 32a and 32b, and send a response signal i.e. measurement information to the outside through the comb electrodes 32a and 32b. Note that, the principles of temperature measurement by the surface acoustic wave device will be described later.

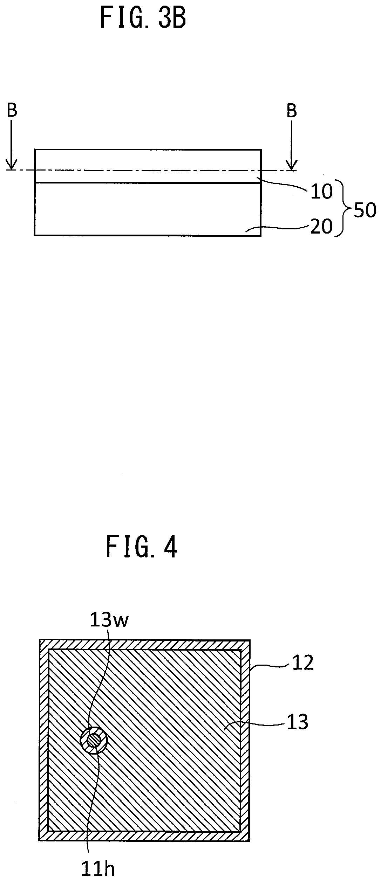

FIG. 3A is a plan view of the wireless temperature sensor 1, and FIG. 3B is a side view of the wireless temperature sensor 1.

As shown in FIG. 3A, the antenna electrode layer 11 having dimensions of approximately 20 mm × 20 mm is provided on the top surface of the wireless temperature sensor 1 having dimensions of approximately 30 mm × 30 mm, that is, the front surface of the lid 10. The external dimensions of the wireless temperature sensor 1 are not limited to approximately 30 mm × 30 mm, but can be any size as long as the wireless temperature sensor 1 is large enough to mount the surface acoustic wave device thereon. The preferable external dimensions of the antenna electrode layer 11 are different depending on the dielectric constant of the lid 10. The above dimensions (approximately 20 mm × 20 mm) are suitable for the lid 10 having a relative dielectric constant of the order of e.g. 9.8. However, the dimensions of the antenna electrode layer 11 are not limited to these.

As shown in FIG. 3B, the container 50 of the wireless temperature sensor 1 is constituted of the lid 10 and the container body 20. The thickness of the entire wireless temperature sensor 1 is approximately 8 mm, but is arbitrarily settable without being limited thereto.

FIG. 4 is a sectional view of the wireless temperature sensor 1 taken along line B-B of FIG. 3B. Note that, the line B-B is also illustrated in FIG. 1 for the sake of understanding the position of a cross section B-B.

As shown in FIG. 4, the GND electrode layer 13 is provided as an internal layer of the insulating substrate 12, and the GND pattern opening 13w is provided on the left of the middle of the GND electrode layer 13 to penetrate the antenna via hole 11h therethrough. The external dimensions of the GND electrode layer 13 are approximately 25 mm × 25 mm, but are not limited to these. It is noted that the GND electrode layer 13 preferably has a larger size for the purpose of further improving characteristics at high frequencies.

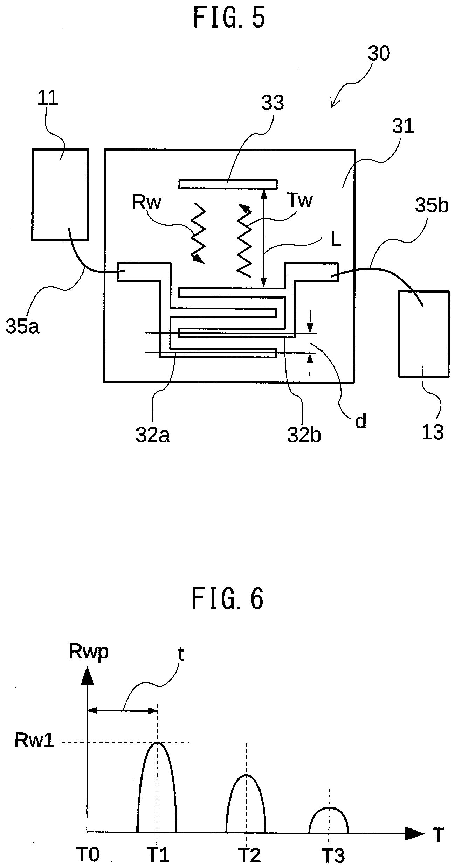

FIG. 5 is a drawing that explains a temperature detection method by the wireless temperature sensor 1.

The temperature detection method by the wireless temperature sensor 1 is based on the principle that the propagation velocity of a surface acoustic wave propagating through the surface acoustic wave device substrate 31 depends on temperature. In other words, the temperature detection method takes advantage of the dependence of the propagation time of an excited surface acoustic wave Tw and a reflected surface acoustic wave Rw on the temperature of the surface acoustic wave device substrate 31. Thus, a calibration table for "propagation time versus temperature of surface acoustic wave device substrate" is created in advance.

First, a not-shown external device sends a high frequency signal having a specific excitation frequency to the above-described antenna (the microstrip antenna constituted of the antenna electrode layer 11, the insulating substrate 12, and the GND electrode layer 13). As shown in FIG. 5, the high frequency signal received by the antenna is applied to the comb electrodes 32a and 32b through the bonding wires 35a and 35b, and brings about an electromechanical transduction effect on the surface acoustic wave device substrate 31. In other words, an excited surface acoustic wave Tw determined by the interelectrode distance d of the comb electrodes is produced in the surface of the surface acoustic wave device substrate 31.

The excited surface acoustic wave Tw propagates on the surface of the surface acoustic wave device substrate 31. The excited surface acoustic wave Tw is reflected from the reflector 33, and returns to the comb electrodes 32a and 32b as a reflected surface acoustic wave Rw. Next, a part of the reflected surface acoustic wave Rw has a mechanoelectrical transduction effect on the surface acoustic wave device substrate 31, and is transduced into a high frequency signal, so that a response signal is transmitted from the antenna to the outside. On the other hand, a part of the reflected surface acoustic wave Rw other than the part transduced into the high frequency signal is reflected from the comb electrodes 32a and 32b, and propagates again on the surface acoustic wave device substrate 31 to the reflector 33. In this manner, while the reflected surface acoustic wave Rw propagates up and down on the surface acoustic wave device substrate 31 between the reflector 33 and the comb electrode 32a or 32b, the reflected surface acoustic wave Rw is partly transduced into the high frequency signal by the comb electrodes 32a and 32b and gradually attenuated.

When the response signal transmitted from the antenna reaches the above external device and the above external device receives the response signal, the above external device measures the time between the transmission of the high frequency signal and the reception of the response signal.

After the time between the transmission of the high frequency signal and the reception of the response signal is measured, the propagation time of the surface acoustic wave in the surface acoustic wave device is calculated from the time between the transmission of the high frequency signal and the reception of the response signal. Then, the temperature of the surface acoustic wave device substrate 31 is obtained from the calculated propagation time based on the calibration table for "propagation time versus temperature of surface acoustic wave device substrate" created in advance. Based on the temperature of the surface acoustic wave device substrate 31, the measurement temperature of an object to which the surface acoustic wave device substrate 31 is attached is determined.

FIG. 6 is a graph showing variations in the strength Rwp of the reflected surface acoustic wave with time in the surface acoustic wave device.

In the graph of FIG. 6, a vertical axis represents the strength Rwp of the reflected surface acoustic wave Rw, while a horizontal axis represents the propagation time T of the surface acoustic wave. Since the reflected surface acoustic wave Rw repeats reflection between the comb electrode 32a or 32b and the reflector 33, the reflected surface acoustic wave Rw is observed in a plurality of timings at times T1 to T3. The strength Rwp of the reflected surface acoustic wave Rw has the highest strength Rw1 at the time T1, that is to say, the reflected surface acoustic wave Rw has the highest strength when being first detected, thus being advantageous for measurement.

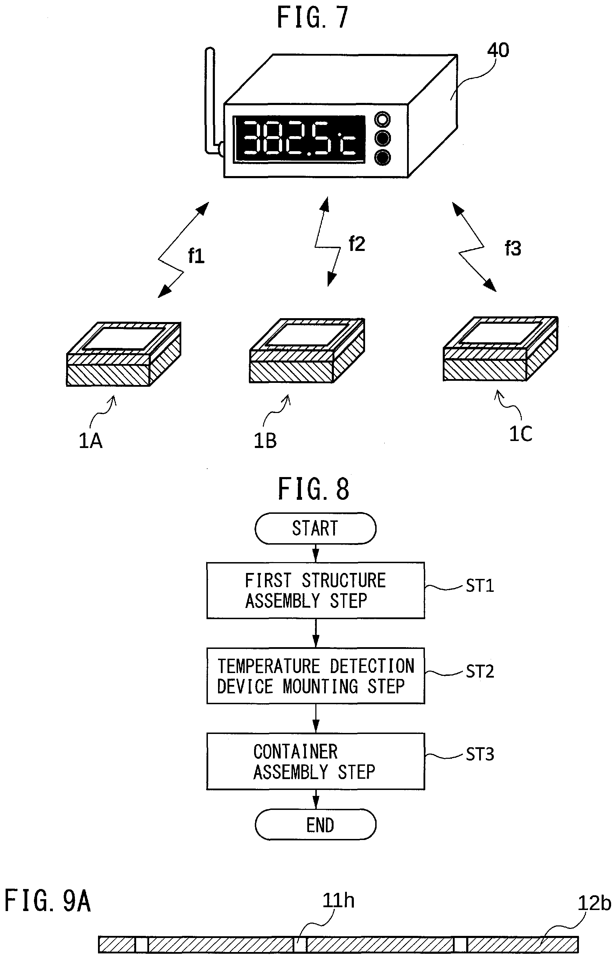

FIG. 7 is a drawing that explains the configuration of a temperature measurement system using the wireless temperature sensors 1.

A temperature display device 40 issues a high frequency signal to the individual plurality of wireless temperature sensors to perform temperature measurement, receives response signals from the individual wireless temperature sensors, and displays temperatures measured by the individual wireless temperature sensors based on the above calibration table.

In an example of FIG. 7, the temperature display device 40 has one display unit for displaying the measured temperatures. The display unit displays one of the temperatures detected by a specific one of the wireless temperature sensors selected by a switch or the like. However, the temperature display device 40 may be provided with individual display units corresponding to each of the plurality of wireless temperature sensors.

The example of FIG. 7 uses three wireless temperature sensors 1A to 1C which have different surface acoustic wave propagation lengths L from one another. The wireless temperature sensors are each prepared with tables for "propagation time versus temperature of surface acoustic wave device substrate".

A high frequency signal having a specific excitation frequency is transmitted from the temperature display device 40 to each wireless temperature sensor. Each wireless temperature sensor produces a response signal which is delayed by a propagation time of a surface acoustic wave. Note that, the wireless temperature sensors 1A to 1C are each preferably attached to objects (not shown) to be measured in a close contact manner so as to have no heat gradient between the object to be measured and the wireless temperature sensor.

By differing the surface acoustic wave propagation lengths L, the surface acoustic waves propagate up and down in the wireless temperature sensors between the comb electrode 32a or 32b and the reflector 33 with propagation times which are different from one wireless temperature sensor to another. Differences in the propagation times serve to identify the wireless temperature sensors 1A to 1C. Furthermore, with the use of the propagation times, the temperatures of the objects (not shown) to be measured can be measured from the calibration tables for "propagation time versus temperature of surface acoustic wave device substrate" corresponding to the individual wireless temperature sensors.

Besides the above method in which the wireless temperature sensors are designed so as to have the different surface acoustic wave propagation lengths L, the wireless temperature sensors may be designed so as to have different operation frequencies. This is realized by, for example, varying the interelectrode distance d of the comb electrodes 32a and 32b. By varying the interelectrode distance d of the comb electrodes, the wireless temperature sensors are each excited by only specific high frequency signals f1 to f3. Thus, the provision of a frequency sweep function (not shown) in the temperature display device 40 allows sequentially transmitting and receiving the high frequency signals f1 to f3 to measure the temperatures of the objects (not shown) to be measured.

The above describes the method which uses the temperature characteristics of the surface acoustic wave propagation time in the surface acoustic wave device substrate 31. However, other methods are also effective in which the reflector 33 has the function of modulating impedance in accordance with temperature and a temperature is measured based on an absolute value of the strength Rwp of a reflected surface acoustic wave, in which a resonant circuit is formed using a piezoelectric element or a ferroelectric element and a temperature is measured using the temperature characteristics of a resonant frequency, and the like.

FIG. 8 is a flowchart showing an overview of a method for manufacturing the wireless temperature sensor 1.

As shown in FIG. 8, the method for manufacturing the wireless temperature sensor 1 is constituted of a first structure assembly process ST1, a temperature detection device mounting process ST2, and a container assembly process ST3. Note that, in the following method for manufacturing the wireless temperature sensor 1, ceramic green sheets, which become ceramic substrates included in the first and second structures by firing, are used. By way of example, a first ceramic substrate (first ceramic green sheet) for the first structure is made of the LTCC, while a second ceramic substrate (second ceramic green sheet) for the second structure is made of the HTCC.

The first structure assembly process ST1 is a process for firing the lid 10. The temperature detection device mounting process ST2 is a process for mounting the temperature detection device 30 on the lid 10. The container assembly process ST3 is a process for joining the lid 10 and the container body 20.

FIGS. 9A to 9F are drawings for explaining the first structure assembly process ST1 of the wireless temperature sensor 1.

First, as shown in FIG. 9A, a first collective insulating substrate 12b is formed using the LTCC ceramic green sheet, and a plurality of antenna via holes 11h are formed using Cu.

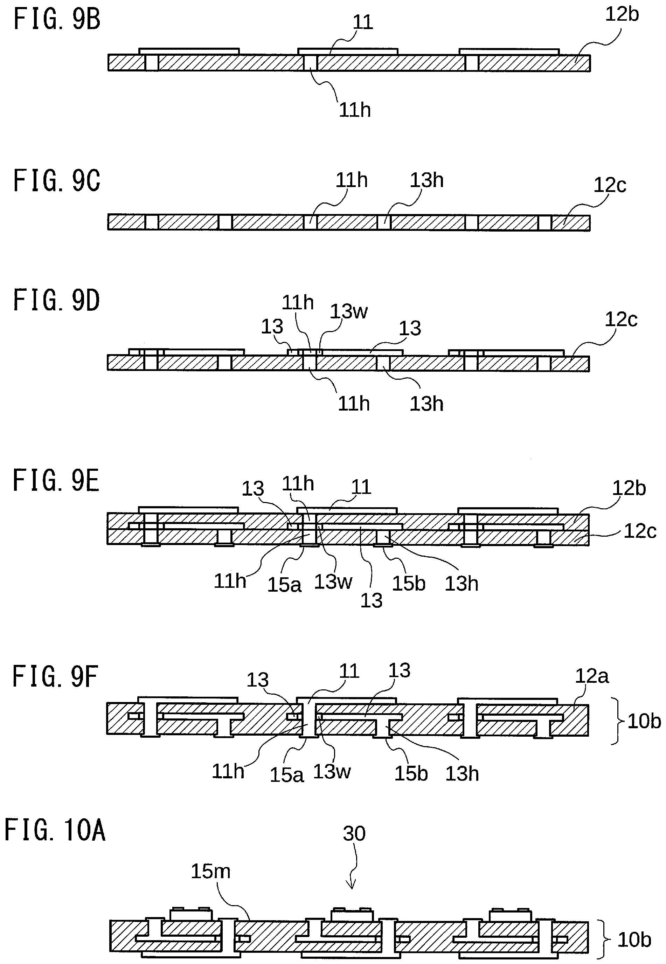

Next, as shown in FIG. 9B, as an antenna electrode forming step, antenna electrode layers 11, which are a plurality of conductor patterns of Cu, are printed on the first collective insulating substrate 12b manufactured in FIG. 9A, in such a manner as to connect each antenna electrode layer 11 to each antenna via hole 11h.

Next, as shown in FIG. 9C, a second collective insulating substrate 12c is formed using the LTCC ceramic green sheet. Moreover, as a via hole forming step, a plurality of antenna via holes 11h are formed using Cu for connection to the antenna electrode layers 11, and a plurality of GND via holes 13h are formed using Cu for connection to GND electrode layers 13.

Next, as shown in FIG. 9D, as a GND electrode forming step, the GND electrode layers 13, which are a plurality of conductor patterns of Cu, are printed on the manufactured second collective insulating substrate 12c. A GND pattern opening 13w is formed in each GND electrode layer 13 at a portion lying over the antenna via hole 11h, and another antenna via hole 11h is formed within the GND pattern opening 13w. Furthermore, each GND electrode layer 13 is connected to each GND via hole 13h.

Next, as shown in FIG. 9E, the first collective insulating substrate 12b is placed on the second collective insulating substrate 12c so as to establish electric connection of the antenna via holes 11h. Next, an electrode pad forming step is performed in which an antenna connection pad 15a is formed using Cu on each antenna via hole 11h, and a GND connection pad 15b is formed using Cu on each GND via hole 13h. Then, the first and second collective insulating substrates 12b and 12c are fired at approximately 890°C, which is a suitable firing temperature for the first and second collective insulating substrates 12b and 12c.

The order of placement of the first and second collective insulating substrates may be reversed. That is to say, after the printing is performed on each of the first and second collective insulating substrates in an inverted position, the firing may be performed in a state of placing the second collective insulating substrate 12c on the first collective insulating substrate 12b. The ceramic green sheet used for forming the first collective insulating substrate 12b and the ceramic green sheet used for forming the second collective insulating substrate 12c are collectively called the first ceramic green sheet.

After the firing, as shown in FIG. 9F, a collective lid 10b is obtained as the first structure. In the first structure, the antenna electrode layer 11, the antenna via hole 11h, and the antenna connection pad 15a are integrally continuous. The GND electrode layer 13, the GND via hole 13h, and the GND connection pad 15b are integrally continuous. The first collective insulating substrate 12b and the second collective insulating substrate 12c form a collective insulating substrate 12a as an integral unit.

In the collective lid 10b described above, the entire conductor patterns are made of Cu, but may be made of Ag instead of Cu.

At the firing temperature (approximately 890°C) described above, neither Ag nor Cu deteriorates to such an extent as to have a substantial effect on the antenna characteristics of the wireless temperature sensor.

FIGS. 10A to 10D are drawings for explaining the temperature detection device mounting process ST2 of the wireless temperature sensor 1.

First, as shown in FIG. 10A, a plurality of temperature detection devices 30 are mounted on a lid mounting surface 15m of the collective lid 10b by metal brazing using an alloy of titanium (Ti) and nickel (Ni). Note that, the metal used in the metal brazing is not limited to this, but may be an alloy of other metals.

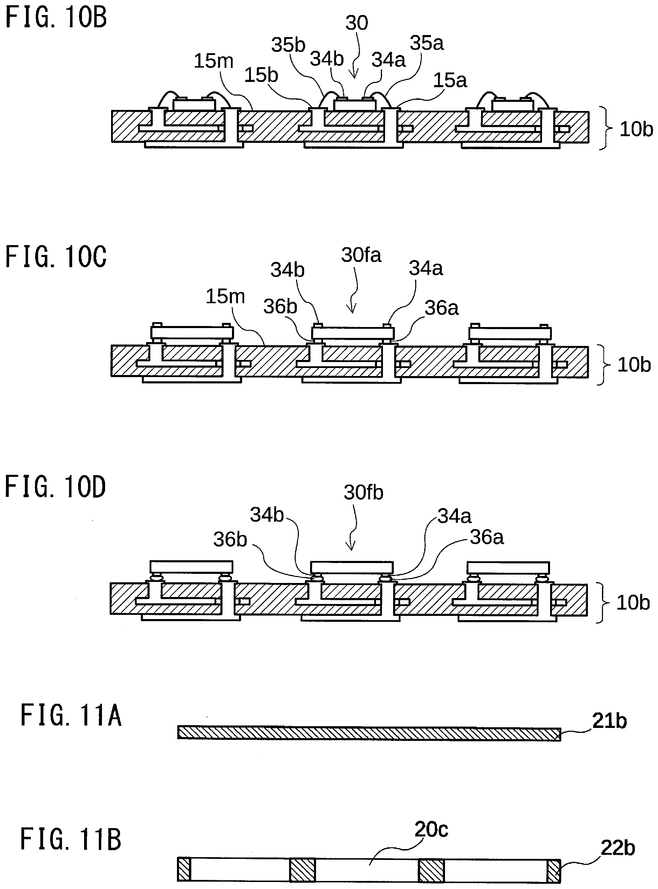

Next, as shown in FIG. 10B, the device bonding pads 34a of the temperature detection devices 30 are each bonded to the antenna connection pads 15a of the collective lid 10b by bonding wires 35a. In a like manner, the device bonding pads 34b of the temperature detection devices 30 are each bonded to the GND connection pads 15b of the collective lid 10b by bonding wires 35b.

FIG. 10C is a sectional view showing another method for joining the temperature detection devices 30 onto the collective lid 10b. As shown in FIG. 10C, gold bumps 36a and 36b are provided on a mounting surface of each temperature detection device 30f.

To be more specific, the device bonding pads 34a and 34b are connected to the gold bumps 36a and 36b on the mounting surface through not shown via holes provided in the temperature detection device 30fa, respectively. Also, the gold bumps 36a and 36b are welded to the antenna connection pads 15a and 15b provided in the lid mounting surface 15m, respectively, by an ultrasonic method or a compression method. The mounting process using this method, as well as products thereby, is contained in the technical scope of the present invention.

FIG. 10D is a sectional view showing yet another method for joining the temperature detection devices 30 onto the collective lid 10b. Each temperature detection device 30f faces the collective lid 10b at a surface in which the device bonding pads 34a and 34b are formed. The temperature detection device 30f is flip-chip mounted onto the collective lid 10b such that the device bonding pad 34a is connected to the antenna connection pad 15a via a gold bump 36a and the device bonding pad 34b is connected to the antenna connection pad 15b via a gold bump 36b. The structure of the flip-chip mounting will be described later.

FIGS. 11A to 11G are drawings for explaining the container assembly process ST3 of the wireless temperature sensor 1.

First, as shown in FIG. 11A, a bottom body collective substrate 21b is formed using the HTCC ceramic green sheet, which is produced by mixing and stirring a ceramic material, a glass filler, a binder, a solvent, and the like.

Next, as shown in FIG. 11B, a side body collective substrate 22b is formed using the HTCC ceramic green sheet, and a plurality of body cavities 20c are provided in the side body collective substrate 22b.

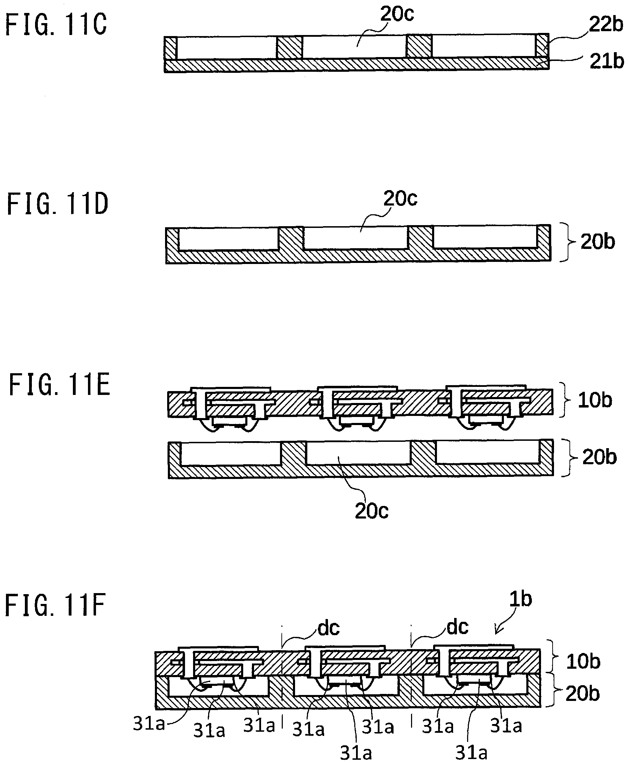

Next, as shown in FIG. 11C, the bottom body collective substrate 21b and the side body collective substrate 22b are fired at a high temperature of approximately 1610°C in a state of placing the side body collective substrate 22b on the bottom body collective substrate 21b. After the firing, as shown in FIG. 11D, a collective container body 20b is obtained.

Next, as shown in FIGS. 11E and 11F, the collective lid 10b on which the temperature detection devices 30 are mounted is placed on and joined to the collective container body 20b in such a manner as to fit the temperature detection devices 30 in the body cavities 20c, and thereby a collective wireless temperature sensor 1b is obtained. Thus, the collective container body 20b, that is, the second structure is disposed on the side of side walls 31a of the temperature detection device 30.

To join the collective lid 10b to the collective container body 20b, for example, gold (Au) and tin (Sn) are formed on joining surfaces and eutectically bonded. Since Au and Sn have high thermal conductivities, the collective container body 20b and the collective lid 10b are thermally connected. Thus, heat obtained by the collective container body 20b (container body 20) is transferred to each temperature detection device 30 through the collective lid 10b (lid 10). Note that, the materials and the method to join the collective container body 20b and the collective lid 10b are not limited to above, but another method such as metal brazing or solid-state bonding by which materials are fusion bonded under a high temperature and a high pressure may be used instead.

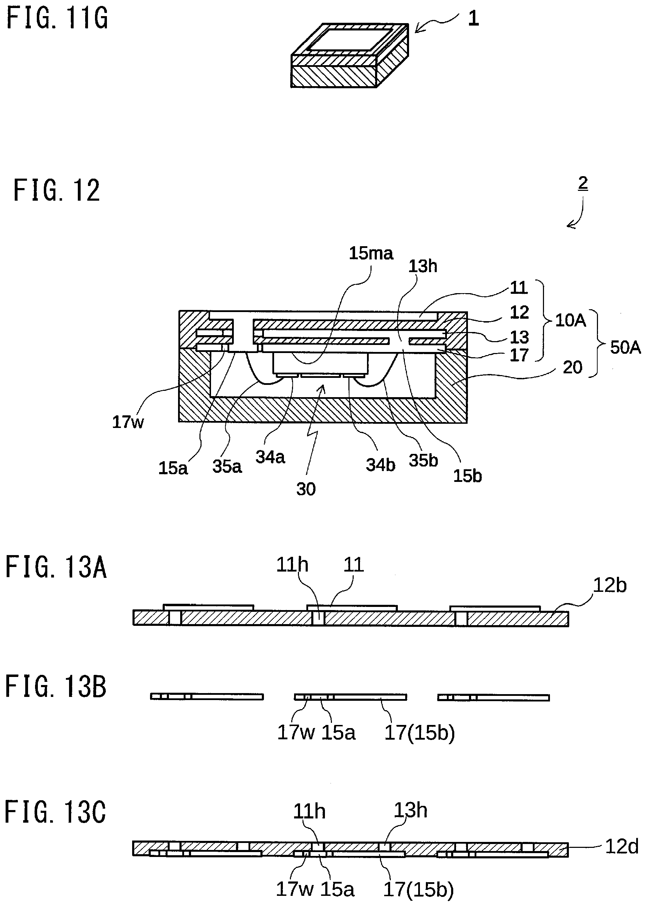

As shown in FIG. 11F, the assembled collective wireless temperature sensor 1b is diced along dicing lines dc to obtain wireless temperature sensors 1 in a chip form as shown in FIG. 11G. Note that, the above example describes a method for manufacturing the three wireless temperature sensors at a time, but the number of the wireless temperature sensors manufactured at a time may be increased.

In the wireless temperature sensor 1, the temperature detection device 30 is mounted on the antenna (lid 10) which is formed by laminating the antenna electrode layer 11 and the GND electrode layer 13 on the insulating substrate 12. Therefore, it is possible to provide the wireless temperature sensor which has an ease of manufacture and an improved reliability.

FIG. 12 is a drawing for explaining the structure of another wireless temperature sensor 2.

The wireless temperature sensor 2 is a modification example of the above wireless temperature sensor 1. The difference between the wireless temperature sensor 2 and the wireless temperature sensor 1 will be hereinafter described, and the description of the same components as those of the wireless temperature sensor 1 will be appropriately omitted.

The difference between the wireless temperature sensor 2 shown in FIG. 12 and the wireless temperature sensor 1 shown in FIG. 1 is the presence or absence of a thermal conductive layer provided in the insulating substrate. The other components are the same.

As shown in FIG. 12, the wireless temperature sensor 2 further has a thermal conductive layer 17 provided on the bottom of the insulating substrate 12. The thermal conductive layer 17 has dimensions of approximately 25 mm × 25 mm, and is thermally connected to the container body 20 at its ends. A thermal conductive layer opening 17w is formed in the thermal conductive layer 17 at a portion lying over the antenna connection pad 15a. However, the shape and the dimensions of the thermal conductive layer 17 can be arbitrarily designed as long as the thermal conductive layer 17 can be thermally connected to the container body 20.

The thermal conductive layer 17 is formed using Cu, but another metal may be used instead. The thermal conductive layer 17 is electrically connected to the GND connection pad 15b. The thermal conductive layer 17 and the GND connection pad 15b may be integrally formed of the same material. Note that, in FIG. 12, the thermal conductive layer 17 may be electrically connected to the antenna connection pad 15a, instead of the GND connection pad 15b.

The temperature detection device 30 is metal brazed onto the thermal conductive layer 17. The device bonding pad 34a of the temperature detection device 30 is electrically connected to the antenna connection pad 15a by the bonding wire 35a. The device bonding pad 34b of the temperature detection device 30 is electrically connected to the GND connection pad 15b (or the thermal conductive layer 17) by the bonding wire 35b.

Referring to FIGS. 13A to 13F, a first structure assembly process of the wireless temperature sensor 2 will be described. Note that, the other processes (a temperature detection device mounting process and a container assembly process) in the manufacturing method of the wireless temperature sensor 2 are the same as those of the wireless temperature sensor 1, so the description thereof will be omitted.

First, as shown in FIG. 13A, a first collective insulating substrate 12b is formed. The formation of the first collective insulating substrate 12b is the same as that of the wireless temperature sensor 1, so a further description is omitted.

Next, as shown in FIG. 13B, a plurality of antenna connection pads 15a and a plurality of GND connection pads 15b (thermal conductive layers 17) are formed using Cu. The thermal conductive layer 17 is provided with a thermal conductive layer opening 17w.

Next, as shown in FIG. 13C, the antenna connection pads 15a and the GND connection pads 15b (thermal conductive layers 17) shown in FIG. 13B are joined to an LTCC ceramic green sheet in which antenna via holes 11h and GND via holes 13h are formed. At this time, the antenna connection pads 15a and the GND connection pads 15b (thermal conductive layers 17) are joined so as to align each thermal conductive layer opening 17w with each antenna via hole 11h. Moreover, the antenna connection pad 15a is connected to the antenna via hole 11h, and the GND connection pad 15b (thermal conductive layer 17) is connected to the GND via hole 13h, to obtain a second collective insulating substrate 12d.

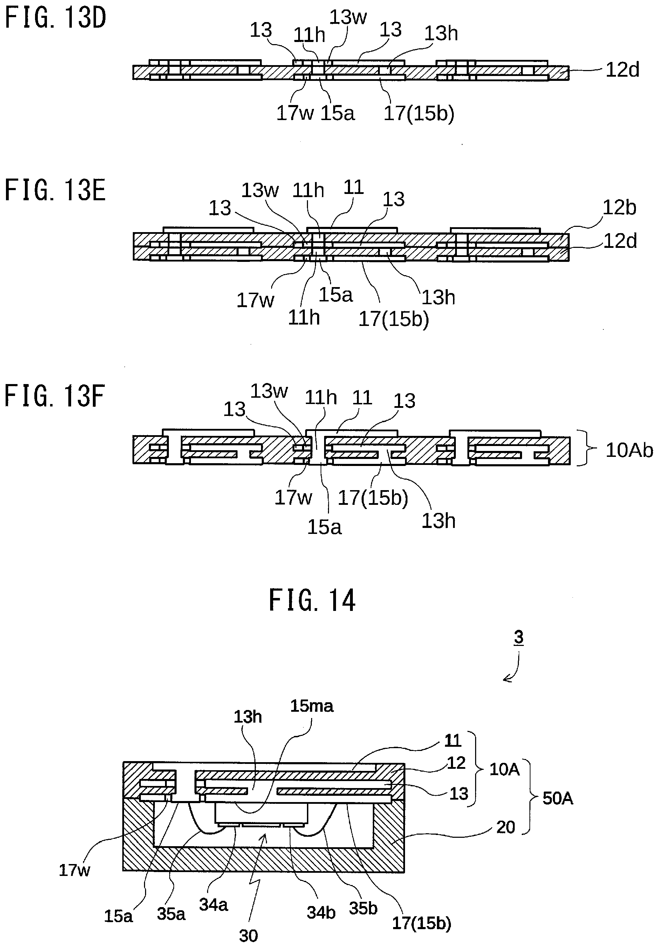

Next, as shown in FIG. 13D, GND electrode layers 13 are printed to the produced second collective insulating substrate 12d so as to connect each GND electrode layer 13 to each GND via hole 13h. Note that, the GND electrode layer 13 is provided with a GND pattern opening 13w, and an antenna via hole 11h is formed within each GND pattern opening 13w.

Next, as shown in FIG. 13E, the first collective insulating substrate 12b is placed on the second collective insulating substrate 12d shown in FIG. 13D, and the antenna via holes 11h and the GND via holes 13h are connected respectively. Moreover, this structure is fired at approximately 890°C to obtain a collective lid 10Ab as shown in FIG. 13F.

The wireless temperature sensor 2 has the thermal conductive layer 17 provided on the bottom of the insulating substrate 12, and the thermal conductive layer 17 is thermally connected to each of the container body 20 and the temperature detection device 30. Thus, the heat of an object to be measured transferred to the container body 20 can be transferred from the container body 20 through the thermal conductive layer 17 to the temperature detection device 30. Therefore, the heat is prevented from being dispersed into a lid 10A, thus serving to further improve the thermal responsivity of the wireless temperature sensor 2.

Since the temperature detection device 30 is connected to the GND connection pad 15b, the wireless temperature sensor 2 has an improved resistance to noise, thus improving the characteristics and the reliability of the wireless temperature sensor 2.

FIG. 14 is a drawing for explaining the structure of yet another wireless temperature sensor 3.

The wireless temperature sensor 3 is a modification example of the wireless temperature sensor 2 described above. The difference between the wireless temperature sensor 3 and the wireless temperature sensor 2 will be hereinafter described, and the description of the same components as those of the wireless temperature sensor 2 will be appropriately omitted.

The difference between the wireless temperature sensor 3 shown in FIG. 14 and the wireless temperature sensor 2 shown in FIG. 12 is the position of the GND via hole. The other components are the same.

As shown in FIG. 14, in the wireless temperature sensor 3, the temperature detection device 30 is fixed on the GND via hole 13h. Here, "fixed on the GND via hole 13h" includes a situation where, as shown in FIG. 14, the approximate center of the temperature detection device 30 coincides with the approximate center of the GND via hole 13h, but is not limited to this. For example, a situation where the approximate center of the GND via hole 13h is situated in the area of the temperature detection device 30, and a situation where the area of the GND via hole 13h is enclosed in the area of the temperature detection device 30 are included therein.

The GND via hole 13h can be disposed at an arbitrary position as well as at the approximate center of the lid 10A. The temperature detection device 30 can be "fixed on the GND via hole 13h" in accordance with the position of the GND via hole 13h.

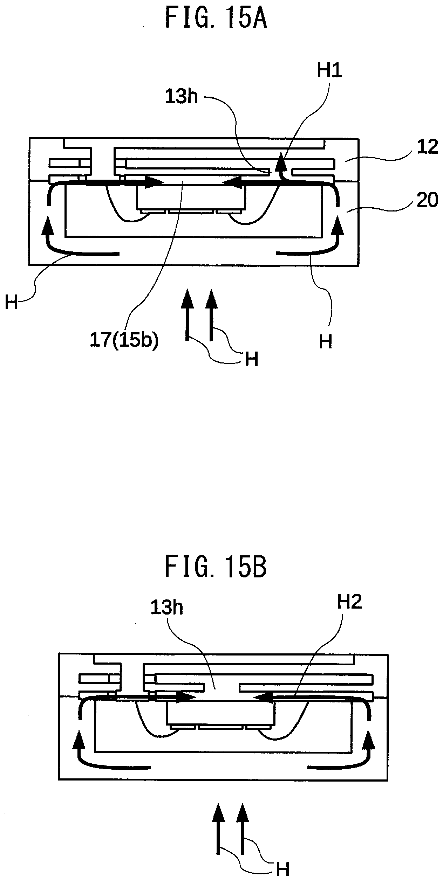

FIG. 15A is a sectional view which schematically shows a heat transfer path of the wireless temperature sensor 2 from a not shown object to be measured. FIG. 15B is a sectional view which schematically shows a heat transfer path of the wireless temperature sensor 3 from a not shown object to be measured. In FIGS. 15A and 15B, hatching to indicate a cross section is omitted for the sake of explanation.

As shown in FIG. 15A, in the wireless temperature sensor 2, as indicated by arrows H, heat that has been transferred from the not shown object to be measured to the container body 20 moves inside the container body 20, and is transferred to the thermal conductive layer 17. While the heat transferred to the thermal conductive layer 17 is moving inside the thermal conductive layer 17 toward the temperature detection device 30, as indicated by an arrow H1, part of the heat moves to the insulating substrate 12 through the GND via hole 13h. This is because the GND via hole 13h made of Cu has a low thermal resistance.

As shown in FIG. 15B, in the wireless temperature sensor 3, as indicated by arrows H, heat which has been transferred from the not shown object to be measured to the container body 20 moves inside the container body 20, and is transferred to the thermal conductive layer 17. As indicated by an arrow H2, the heat transferred to the thermal conductive layer 17 moves inside the thermal conductive layer 17 toward the temperature detection device 30. At this time, since no GND via hole 13h having a low thermal resistance is present on the way to reaching the temperature detection device 30, almost all of the heat flows into the temperature detection device 30 through the thermal conductive layer 17.

As described above, according to the wireless temperature sensor 3, since the temperature detection device 30 is fixed on the GND via hole 13h, it is possible to reduce an amount of heat which moves to the inside of the lid 10 through the via hole. Therefore, the wireless temperature sensor 3 has an improved responsivity to temperature measurement and a reduced variation in antenna characteristics owing to a thermal effect.

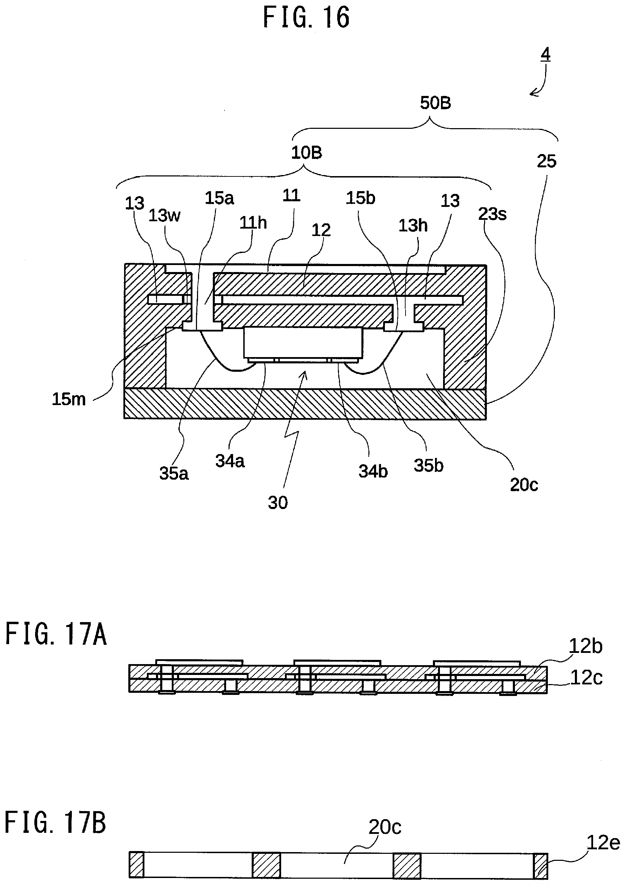

FIG. 16 is a drawing for explaining the structure of yet another wireless temperature sensor 4.

The wireless temperature sensor 4 is a modification example of the wireless temperature sensor 1 described above. The difference between the wireless temperature sensor 4 and the wireless temperature sensor 1 will be hereinafter described, and the description of the same components as those of the wireless temperature sensor 1 will be appropriately omitted.

The difference between the wireless temperature sensor 4 shown in FIG. 16 and the wireless temperature sensor 1 is the shapes of the first structure and the second structure. The other components are the same.

As shown in FIG. 16, an insulating substrate 12 of a container body 10B, that is, a first structure of the wireless temperature sensor 4 has the shape of a container having a container body side portion 23s. A lid 25, that is, a second structure has the shape of a lid.

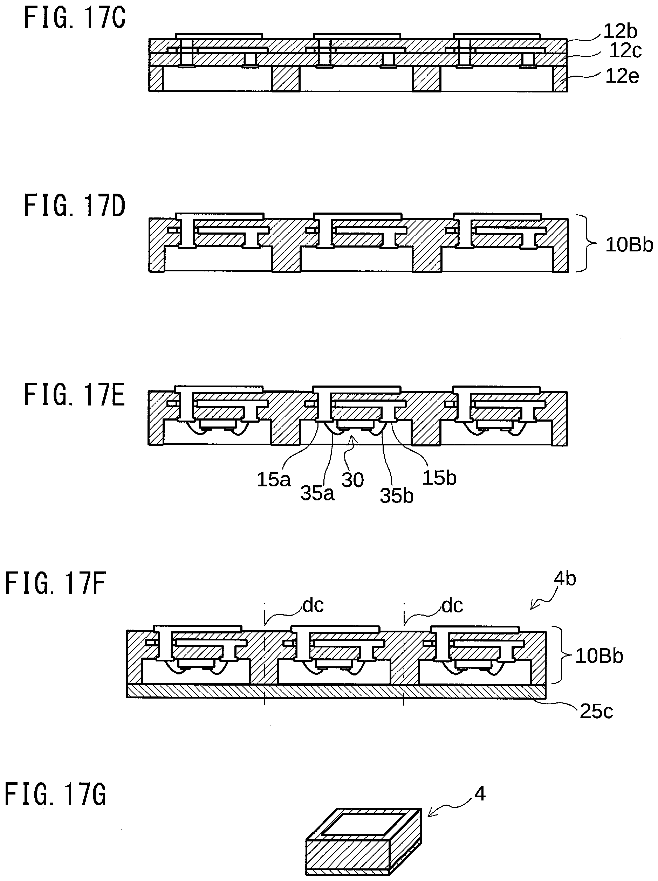

Referring to FIGS. 17A to 17G, a method for manufacturing the wireless temperature sensor 4 will be described. The description of the same steps as those of the wireless temperature sensor 1 will be appropriately omitted.

First, as shown in FIG. 17A, a first collective insulating substrate 12b and a second collective insulating substrate 12c are produced, and the first collective insulating substrate 12b is placed on the second collective insulating substrate 12c. Note that, these steps are the same as those explained with reference to FIGS. 9A to 9E, so a further description is omitted.

Next, as shown in FIG. 17B, a third collective insulating substrate 12e is formed using an LTCC ceramic green sheet. A plurality of body cavities 20c are formed in the third collective insulating substrate 12e.

Next, as shown in FIG. 17C, the first collective insulating substrate 12b and the second collective insulating substrate 12c are placed on the third collective insulating substrate 12e and fired at approximately 890°C. By the firing, as shown in FIG. 17D, a collective container body 10Bb in which the first collective insulating substrate 12b, the second collective insulating substrate 12c, and the third collective insulating substrate 12e are integrated is obtained.

Next, as shown in FIG. 17E, a temperature detection device 30 is mounted in each of the body cavities 20c of the collective container body 10Bb, and connected to an antenna connection pad 15a and a GND connection pad 15b by bonding wires 35a and 35b, respectively, thus completing the assembly of the collective container body 10Bb.

Next, as shown in FIG. 17F, a bottom body collective substrate 25c is formed using an HTCC ceramic green sheet. The bottom body collective substrate 25c is eutectically bonded to the collective container body 10Bb using Au or Sn, to form a collective wireless temperature sensor 4b. Then, the collective wireless temperature sensor 4b is diced into chips along dicing lines dc shown by alternate long and short dashed lines. The lower side of FIG. 17F is a perspective view of the wireless temperature sensor 4 in a chip form.

In the wireless temperature sensor 4, since the first structure is formed into the shape of a container and the second structure is formed into the shape of a lid i.e. a plane, materials can be chosen from a wider range. For example, in an instance where the wireless temperature sensor is used for measuring a temperature with higher precision, a thin film-shaped metal plate (which may be an insulating substrate having an oxide film on its surfaces, if necessary) may be used as a lid 25 to improve responsivity. Also, forming the lid 25 of a polymeric material and joining the lid 25 to the container body 10B eliminate the need for a firing step, thus bringing efficiency to production.

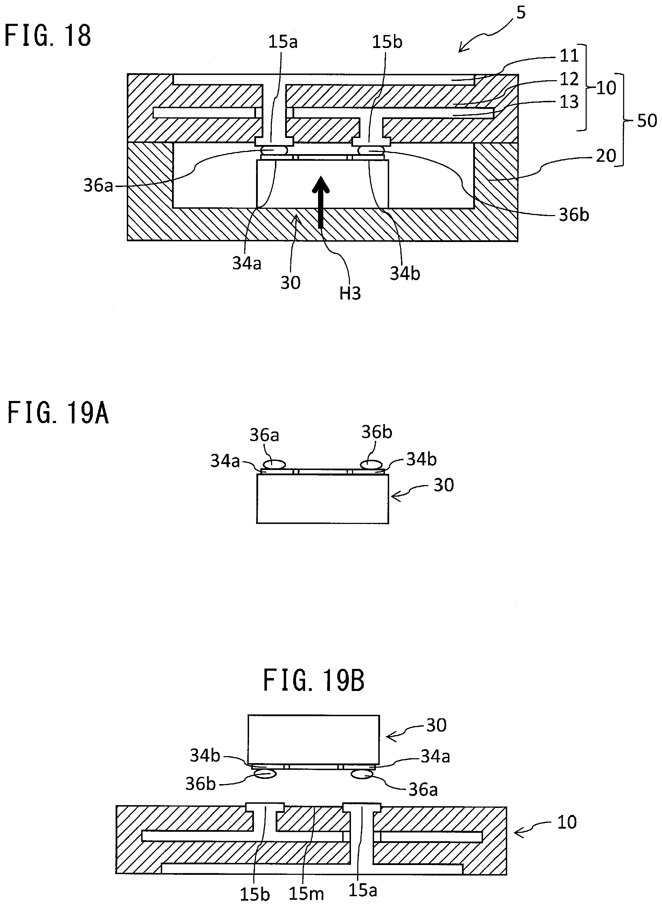

FIG. 18 is a drawing for explaining the structure of yet another wireless temperature sensor 5.

The wireless temperature sensor 5 is a modification example of the wireless temperature sensor 1 described above. The difference between the wireless temperature sensor 5 and the wireless temperature sensor 1 will be hereinafter described, though the description of the same components as those of the wireless temperature sensor 5 will be appropriately omitted.

The difference between the wireless temperature sensor 5 shown in FIG. 18 and the wireless temperature sensor 1 shown in FIG. 1 is a method for mounting the temperature detection device and the contact between the temperature detection device and the container body. The other components are the same.

As shown in FIG. 18, a temperature detection device 30 is flip-chip mounted on the lid 10 in such a position that its surface having the comb electrodes 32a and 32b, the reflector 33, and the like face the lid 10. The device bonding pad 34a is connected to the antenna connection pad 15a via the gold bump 36a, and the device bonding pad 34b is connected to the GND connection pad 15b via the gold bump 36b.

As shown in FIG. 18, in the wireless temperature sensor 5, the temperature detection device 30 contacts the container body 20 on the opposite surface to the surface facing the lid 10. However, the temperature detection device 30 and the container body 20 may be in close vicinity to each other in such an extent that heat is directly transferred therebetween, instead of contacting each other. A portion of the temperature detection device 30 which contacts or almost contacts the container body 20 and, if not contacting, the distance between the temperature detection device 30 and the container body 20 can be designed arbitrarily, as long as heat is directly transferred therebetween.

A temperature detection device mounting process of the wireless temperature sensor 5 will be described below with reference to FIGS. 19A to 19C. Note that, the other processes (a first structure assembly process and a container assembly process) of the wireless temperature sensor 5 are the same as those of the wireless temperature sensor 1, so the description thereof will be omitted. Note that, the thickness of inside space of the container body 20 corresponds to the height between the lid mounting surface 15m and the opposite surface of the temperature detection device 30 to the lid 10. For the sake of convenience of explanation, a method for manufacturing a single wireless temperature sensor will be described. However, a manufacturing method in which a plurality of wireless temperature sensors are produced at a time and then diced into individual chips may be used instead.

First, as shown in FIG. 19A, a gold bump 36a is formed on the device bonding pad 34a of the temperature detection device 30. A gold bump 36b is formed on the device bonding pad 34b of the temperature detection device 30.

Next, as shown in FIG. 19B, the temperature detection device 30 is turned upside down, and placed on the lid mounting surface 15m such that the gold bump 36a contacts the antenna connection pad 15a and the gold bump 36b contacts the GND connection pad 15b.

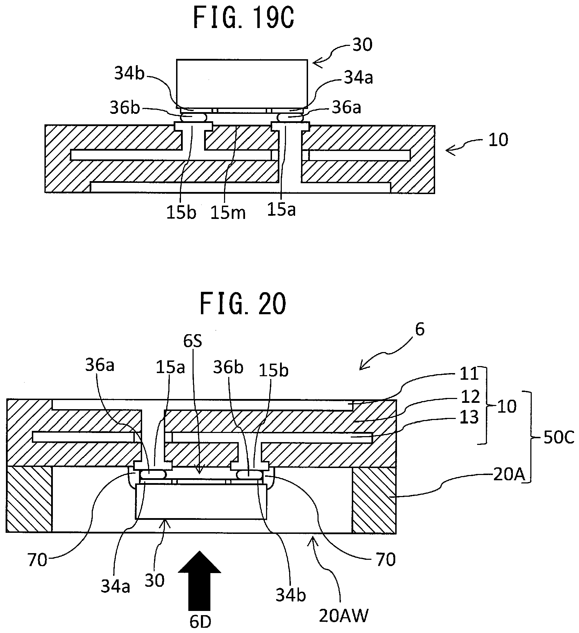

Next, the bonding pads (15a, 15b, 34a, and 34b) and the gold bumps 36a and 36b are fusion bonded or joined by ultrasonic vibration, and thus, as shown in FIG. 19C, the temperature detection device 30 is mounted on the lid 10. The temperature detection device mounting process of the wireless temperature sensor 5 is now completed.

In the wireless temperature sensor 5, the temperature detection device 30 and the container body 20 contact each other, or are in close vicinity to each other in such an extent that heat is directly transferred therebetween. Thus, the heat which has been transferred from an object to be measured to the container body 20 can be directly transferred from the container body 20 to the temperature detection device 30, as indicated by an arrow H3 of FIG. 18. Therefore, the wireless temperature sensor has an improved responsivity to temperature measurement.

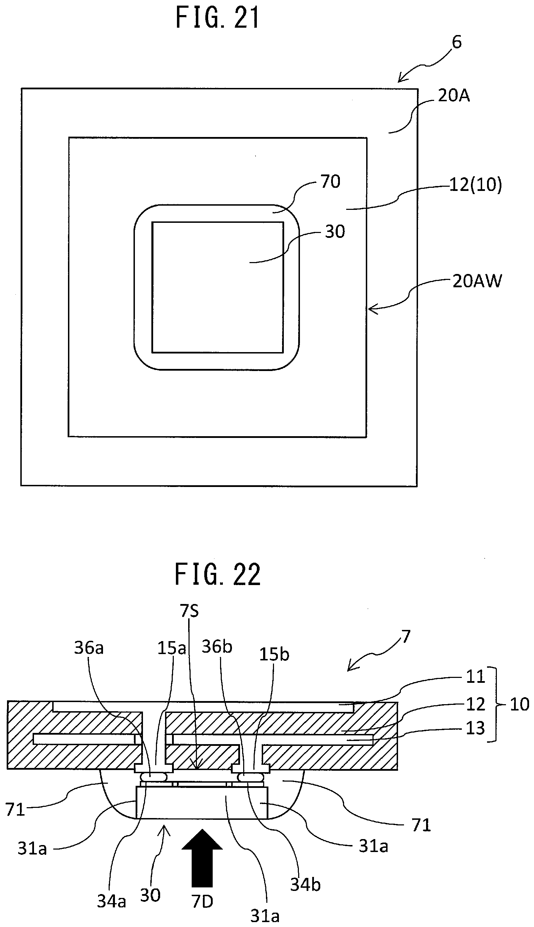

FIG. 20 is a drawing for explaining the structure of yet another wireless temperature sensor 6. FIG. 21 is a drawing in which the wireless temperature sensor 6 is viewed from a direction 6D in FIG. 20.

The wireless temperature sensor 6 is a modification example of the wireless temperature sensor 5 described above. The difference between the wireless temperature sensor 6 and the wireless temperature sensor 5 will be hereinafter described, though the description of the same components as those of the wireless temperature sensor 5 will be appropriately omitted.

The difference between the wireless temperature sensor 6 shown in FIG. 20 and the wireless temperature sensor 5 shown in FIG. 18 is the presence or absence of an opening provided in the container body on an opposite side to a side joined to the lid. The other components are the same.

A container body 20A of the wireless temperature sensor 6 has an opening 20AW on an opposite side to a side facing the lid 10. Thus, as shown in FIG. 21, the temperature detection device 30 is exposed outside.

The opening 20AW may have an arbitrary shape such as a circle, a polygon, and an irregular shape, in addition to a rectangle. To obtain the container body 20A, for example, a container body is produced without using the bottom body collective substrate 21b described with reference to FIG. 10A. However, the container body 20A may be produced by another method.

A sealing resin 70 fills a gap between the temperature detection device 30 and the lid 10 at the edge of the temperature detection device 30, so as to form space 6S which is sealed with the lid 10, the temperature detection device 30, and the sealing resin 70 in an airtight manner. The space 6S contains the comb electrodes 32a and 32b and the reflector 33 therein.

In the wireless temperature sensor 6, the opening 20AW is provided in the container body 20A on the opposite side to the side joined to the lid 10, and the temperature detection device 30 is exposed outside. This makes it possible to dispose the temperature detection device 30 near an object to be measured during temperature measurement. Therefore, the heat of the object to be measured is easily transferred to the temperature detection device 30, thus improving the thermal responsivity of the wireless temperature sensor.

In the wireless temperature sensor 6, the comb electrodes 32a and 32b and the reflector 33 are contained in the air-tightly sealed space 6S, which neither gas nor fluid can enter from outside. This improves the stability of the antenna characteristics of the wireless temperature sensor. Note that, the space 6S may be evacuated. The evacuated space 6S further improves the stability of the antenna characteristics of the wireless temperature sensor. Note that, when the temperature detection device 30 can be directly attached to an object to be measured, the container body 20A itself may be eliminated.

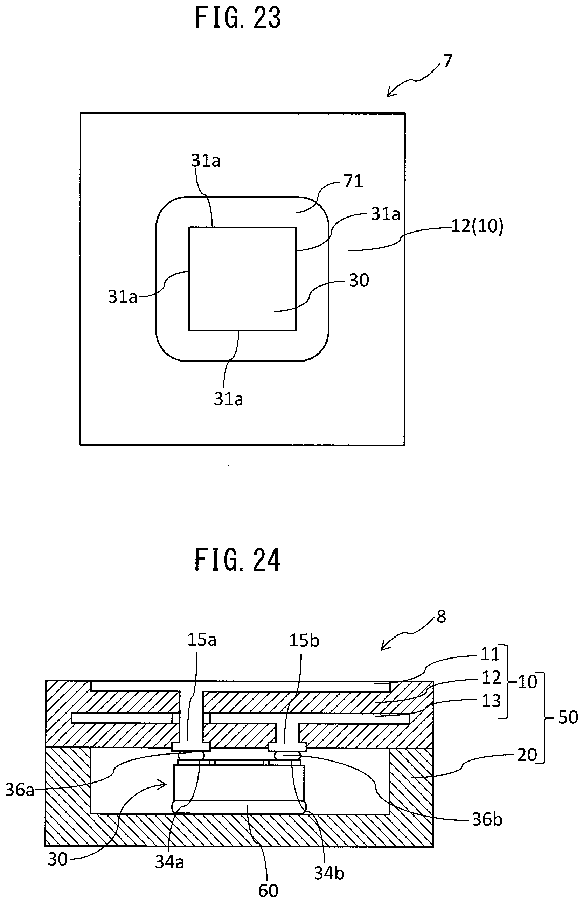

FIG. 22 is a drawing for explaining the structure of yet another wireless temperature sensor 7. FIG. 23 is a drawing in which the wireless temperature sensor 7 is viewed from a direction 7D in FIG. 22.

The wireless temperature sensor 7 is a modification example of the wireless temperature sensor 6 described above. The difference between the wireless temperature sensor 7 and the wireless temperature sensor 6 will be hereinafter described, though the description of the same components as those of the wireless temperature sensor 6 will be appropriately omitted.

As shown in FIG. 22, the wireless temperature sensor 7 does not have the container body 20A itself, and a sealing resin 71 constitutes a second structure instead. The sealing resin 71 is formed on the side of the side walls 31a of the temperature detection device 30 so as to cover the side walls 31a of the temperature detection device 30.

Since the wireless temperature sensor 7 has no container body, the temperature detection device 30 is directly attached to an object to be measured with ease, thus further improving the thermal responsivity of the wireless temperature sensor.

FIG. 24 is a drawing that explains the structure of yet another wireless temperature sensor 8.

The wireless temperature sensor 8 is a modification example of the wireless temperature sensor 5 described above. The difference between the wireless temperature sensor 8 and the wireless temperature sensor 5 will be hereinafter described, though the description of the same components as those of the wireless temperature sensor 5 will be appropriately omitted.

The difference between the wireless temperature sensor 8 shown in FIG. 24 and the wireless temperature sensor 5 shown in FIG. 18 is the presence or absence of a thermal conductor. The other components are the same.

As shown in FIG. 24, the wireless temperature sensor 8 further includes a thermal conductor 60 disposed between the temperature detection device 30 and the container body 20. The thermal conductor 60 is thermally connected to both of the temperature detection device 30 and the container body 20 by, for example, bonding with a high thermal conductive resin. Alternatively, the thermal conductor 60 may be caught between the temperature detection device 30 and the container body 20, instead of being bonded.

The thermal conductor 60 is made of a silver paste having a high thermal conductivity. However, the thermal conductor 60 may be made of another material having a high thermal conductivity such as an epoxy resin, a silicone resin, a ceramic material, a metal, and a high-temperature-resistant resin, instead of the silver paste.

Furthermore, the thermal conductor 60 preferably has a low thermal expansion coefficient in order to keep the airtightness between the lid 10 and the container body 20.

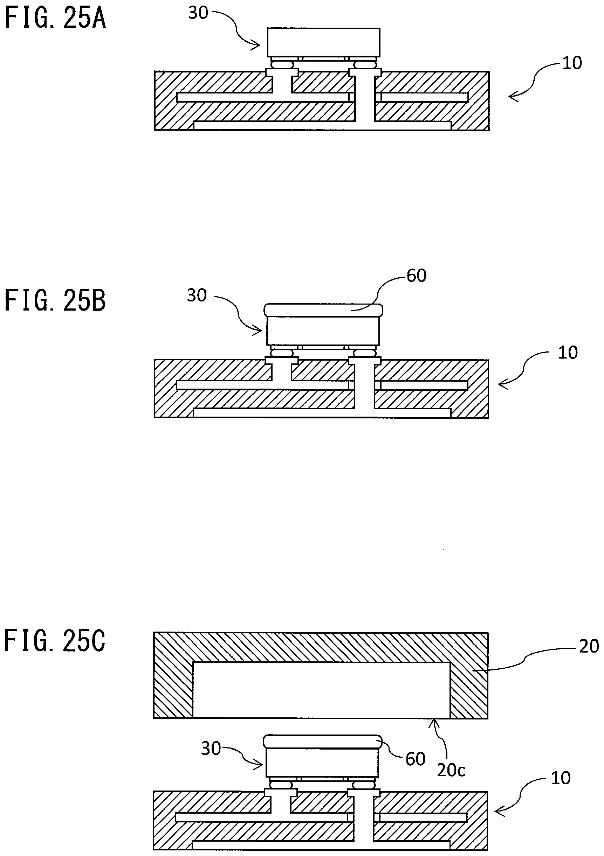

Referring to FIG. 25, a temperature detection device mounting process and an entirety assembly process of the wireless temperature sensor 8 will be described. Note that, a first structure assembly process of the wireless temperature sensor 8 is the same as that of the wireless temperature sensor 1, so the description thereof will be omitted.

First, as shown in FIG. 25A, a temperature detection device 30 is flip-chip mounted on the lid 10. This step is the same as the step described above with reference to FIGS. 19A to 19D, so a further description is omitted.

Next, as shown in FIG. 25B, a thermal conductor 60, that is, a silver paste formed by firing a mixture of a binder and silver particles is bonded to the surface of the temperature detection device 30 on the opposite side to the side facing the lid 10 with a high thermal conductive resin.

Next, as shown in FIG. 25C, the container body 20 is joined to the lid 10 on which the temperature detection device 30 is mounted in such a manner that the temperature detection device 30 is fitted in the body cavity 20c, and thereby the wireless temperature sensor 8, as shown in FIG. 20, is obtained. Note that, a joining method is the same as that described above with reference to FIGS. 11E and 11F, so a further description is omitted.

Note that, in contrast to the above method, after the thermal conductor 60 is bonded to the bottom of the container body 20, the container body 20 may be placed on and joined to the lid 10 in such a manner that the thermal conductor 60 contacts the temperature detection device 30, to obtain the wireless temperature sensor 8.

According to the wireless temperature sensor 8, since the thermal conductor 60 is disposed between the temperature detection device 30 and the container body 20, the heat of an object to be measured which has been transferred to the container body 20 is transferred to the temperature detection device 30 through the thermal conductor 60. Therefore, the heat of the object to be measured is easily transferred to the temperature detection device 30, thus improving the thermal responsivity of the wireless temperature sensor.

FIG. 26 is a drawing for explaining the structure of yet another wireless temperature sensor 9.

The wireless temperature sensor 9 is a modification example of the above wireless temperature sensor 5. The difference between the wireless temperature sensor 9 and the wireless temperature sensor 5 will be hereinafter described, and the description of the same components as those of the wireless temperature sensor 5 will be appropriately omitted.

The difference between the wireless temperature sensor 9 shown in FIG. 26 and the wireless temperature sensor 5 shown in FIG. 18 is the structure of the container body. The other components are the same.

Just as with the container body 20 of the wireless temperature sensor 1, a container body 20B of the wireless temperature sensor 9 is made of Al₂O₃, that is, the HTCC. However, as contrast to the container body 20, the container body 20B has a porous structure which enables gas or fluid to pass therethrough. For example, when the container body 20B is made of a metal, a mesh structure may be adopted as a structure which enables gas or fluid to pass therethrough. The container body 20B can be designed, in accordance with the material of the container body 20B, so as to have a structure which enables gas or fluid to pass therethrough.

A sealing resin 70 fills a gap between the temperature detection device 30 and the lid 10 at the edge of the temperature detection device 30, so as to form space 9S which is sealed with the lid 10, the temperature detection device 30, and the sealing resin 70 in an airtight manner. The space 9S contains the comb electrodes 32a and 32b and the reflector 33 therein.

In the wireless temperature sensor 9, gas or fluid passes through the container body 20B. Thus, as indicated by arrows H4 in FIG. 26, gas or fluid around the wireless temperature sensor 9 can get into space (except for the space 9S) enclosed by the lid 10 and the container body 20B through the container body 20B. Therefore, the temperature detection device 30 can directly detect the temperature of the gas or the fluid, thus allowing the wireless temperature sensor 9 to measure an environmental temperature (ambient temperature) with higher precision.

In the wireless temperature sensor 9, the comb electrodes 32a and 32b and the reflector 33 are contained in the space 9S sealed with the sealing resin 70 in an airtight manner. Thus, the gas or the fluid which has flowed into the space enclosed with the lid 10 and the container body 20B through the container body 20B cannot enter the space 9S. This improves the stability of the antenna characteristics of the wireless temperature sensor. It is noted that the space 9S may be evacuated. The evacuated space 9S further improves the stability of the antenna characteristics of the wireless temperature sensor.

The wireless temperature sensors 1 to 9 described above are applicable to devices which require remote sensing of temperature measurement.

The present invention can be variously modified, substituted, and amended within the spirit and the scope of the present invention, and the above embodiments can be arbitrarily combined.

### EXPLANATION OF NUMERALS

1, 1A to 1C, 2, 3, 4, 5, 6, 7, 8, 9... wireless temperature sensor
1b... collective wireless temperature sensor
10, 10A, 25... lid
10b, 10Ab, 10Bb... collective lid
11... antenna electrode
11h... antenna via hole
12... insulating substrate
12b... first collective insulating substrate
12c, 12d... second collective insulating substrate
12e... third collective insulating substrate
13... GND electrode
13h... GND via hole
13w... GND pattern opening
15a... antenna connection pad
15b... GND connection pad
15m, 15ma... lid mounting surface
17... thermal conductive layer
17w... thermal conductive layer opening
20, 10B... container body
20b... collective container body
20c... body cavity
21b, 25c... bottom body collective substrate
22b... side body collective substrate
23s... container body side portion
30, 30f... temperature detection device
31... surface acoustic wave device substrate
32a, 32b... comb electrode
33... reflector
34a, 34b... device bonding pad
35... bonding wire
36a, 36b... gold bump
40... temperature display device
50, 50A, 50B, 50C, 50D... container
70, 71... sealing resin
101, 121... container body
107, 125... lid
104, 123... diaphragm
130... groove
102, 103, 122... external terminal
105, 106, 124, 128... lead wire
108, 126... coil
Tw... excited surface acoustic wave
Rw... reflected surface acoustic wave
Rwp... strength (of the reflected surface acoustic wave)
T, T1, T2, T3... time
d, d1, d2, d3... interelectrode distance
f1, f2, f3... high frequency signal
t... propagation time
ST1... first structure assembly process
ST2... temperature detection device mounting process
ST3... container assembly process
dc... dicing line

## Claims

1. A wireless temperature sensor comprising:
a first structure which has an antenna having an antenna electrode and a GND electrode disposed in an insulating substrate;
a temperature detection device fixed on an opposite surface of the first structure to a surface in which the antenna electrode is disposed; and
a second structure disposed on the side of a side wall of the temperature detection device and joined to the first structure, wherein
the temperature detection device is fixed on the first structure so as to be electrically connected to the antenna electrode and the GND electrode.

2. The wireless temperature sensor according to claim 1, wherein the temperature detection device is fixed so as to contact the inside of the second structure.

3. The wireless temperature sensor according to claim 1, wherein the second structure has an opening on the opposite side to the side joined to the first structure.

4. The wireless temperature sensor according to claim 1, further comprising a thermal conductor disposed between the second structure and the temperature detection device.

5. The wireless temperature sensor according to claim 1, wherein the second structure has a porous structure or a mesh structure.

6. The wireless temperature sensor according to any one of claims 1 to 5, further comprising a thermal conductive layer which is formed in the insulating substrate and thermally connected to the temperature detection device and the second structure.

7. The wireless temperature sensor according to claim 6, further comprising:
a via hole formed in the insulating substrate so as to conduct between the GND electrode and the thermal conductive layer, wherein
the temperature detection device is fixed on the via hole on the thermal conductive layer.

8. The wireless temperature sensor according to any one of claims 1 to 7, wherein
the first structure is formed from a first ceramic substrate having a lower firing temperature than a second ceramic substrate; and
the second structure is formed from the second ceramic substrate having a higher firing temperature than the first ceramic substrate.

9. The wireless temperature sensor according to claim 8, wherein
the first ceramic substrate is made of LTCC; and
the second ceramic substrate is made of HTCC.

10. The wireless temperature sensor according to any one of claims 1 to 9, wherein the antenna electrode and the GND electrode are made of silver (Ag) or copper (Cu).

11. The wireless temperature sensor according to any one of claims 1 to 10, further comprising a protective layer for covering the antenna electrode.
